# EUROPEAN PATENT SPECIFICATION

(11) **EP 1 788 121 B1**
(45) Date of publication and mention of the grant of the patent: **03.07.2013**
(21) Application number: 06255919.0
(22) Date of filing: 20.11.2006
(51) Int. Cl.: C23C 28/04, B22C 3/00, B22C 9/10, C23C 28/00, C23C 16/30, C23C 16/02, C23C 16/40

(54) **Barrier coating system for refractory metal core**
Sperrschichtsystem für Feuerfestmetallkern
Système de couche barrière thermique pour un substrat métallique

(30) Priority: 21.11.2005 US 285564
(43) Date of publication of application: 23.05.2007
(73) Proprietor: United Technologies Corporation, Hartford, CT 06101 (US)
(72) Inventor: Persky, Joshua, Boulder, CO 80301 (US)
(74) Representative: Leckey, David Herbert

(56) References cited:
- EP-A- 0 810 046
- EP-A- 1 306 147
- EP-A- 1 524 045
- EP-A- 1 531 019

## Description

### BACKGROUND OF THE INVENTION

### (1) Field of the Invention

The present invention relates to a barrier coating system for refractory metal cores used in systems for casting products such as turbine engine components.

### (2) Prior Art

Thermal mismatch stresses that develop in a baseline coating system, alumina on molybdenum, may lead to microcracking, creating an oxygen permeable barrier coating. Such a coating does not provide a robust enough oxidation barrier during the standard shellfire cycle to protect the molybdenum substrate. In addition to the transverse micro crack, thicker coatings may suffer from crack deflection at the substrate interface causing gross delaminating that leads to failure of the refractory metal core casting. Historically, a Sebastian pull test has shown that failure stresses greater than 5171 KNm⁻² (0.75 ksi) are required for repeatable castings.

Many castings using the refractory metal core technology will use six or more cores requiring coating yield to be greater than 95%. Thus, a coating system for a refractory metal core should have the following physical requirements: (1) non-reactive with molten nickel alloy; (2) phase stable at 10⁻³ torr and 1600°C; (3) removable from the nickel alloy after casting without debiting the alloy properties; (4) provide oxidation protection during the shellfire stages of investment casting; and (5) less than 50 microns thick.

Mixed oxide deposition by chemical vapor deposition has been suggested as a longer-term solution and method to match thermal expansion coefficients and eliminate thermal mismatch stresses. Mixed oxide deposition is very difficult to control due to the catalytic effect that one species usually has on the other. Many mixed oxides also run the risk of varying in composition across the substrate as a result in different reaction rates.

A refractory metal core having a carbide or nitride layer between a core substrate and a ceramic layer is disclosed in EP-A-1524045. An article having the features of the preamble of claim 1 is disclosed in EP-A-0810046.

### SUMMARY OF THE INVENTION

In accordance with the present invention, a bond coat for the baseline system is provided which increases adherence and lowers thermal mismatch stress.

According to the invention there is provided an article as claimed in claim 1.

The present invention in a preferred embodiment relates to a refractory metal core system for use in casting a product. The refractory metal core system broadly comprises a refractory metal core and a layer of aluminum nitride deposited on the refractory metal core, which layer of aluminum nitride acts as a bond coat. The system further comprises a layer of alumina deposited on top of the aluminum nitride layer.

The present invention also provides a method for forming a refractory metal core system for use in a casting system as claimed in claim 8

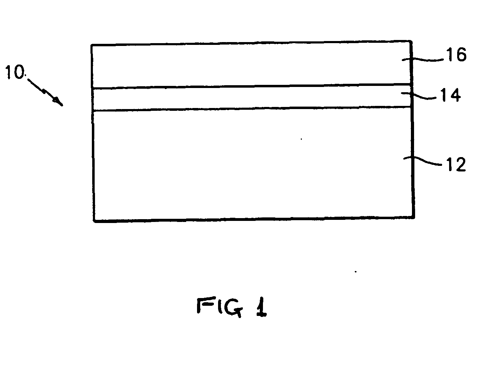

Other details of the barrier coating system for refractory metal cores in according with the present invention, as well as other advantages, are set forth in the following detailed description and the accompanying drawing(s) wherein like reference numerals depict like elements.

### BRIEF DESCRIPTION OF THE DRAWINGS

The FIGURE illustrates a refractory metal core having a coating system in accordance with the present invention.

### DETAILED DESCRIPTION OF THE PREFERRED EMBODIMENT(S)

Referring now to the FIGURE, there is shown there a refractory metal core system in accordance with the present invention. The refractory metal core system may be used in casting processes for forming products such as cooling passages in an airfoil portion of a turbine engine component such as a turbine engine blade or vane.

The refractory metal core system 10 comprises a refractory metal core substrate 12, a layer 14 of aluminum nitride deposited on a surface of the substrate 12, and a barrier coating layer 16 deposited on the aluminum nitride layer 14. The substratate 12 is formed from a metal selected from the group consisting of molybdenum and molybdenum alloys. As used herein, the term "molybdenum alloys" refers to alloys. having more than 50% by weight of molybdenum. The substrate 12 may be a rolled foil having a thickness in the range of from 300 to 500 microns. If the substrate 12 is formed from molybdenum, the substrate has a coefficient of thermal expansion of 4.5 ppm/°C and a use temperature of 350°C. Further, it may be removed using 2H₂O*2HNO₃*1H₂SO₄.

The aluminum nitride layer 14 has a thickness of less than 50 microns. Preferably, the aluminum nitride layer 14 has a thickness in the range of from 3.0 to 5.0 microns. The aluminum nitride layer 14 may be deposited onto the substrate 12 using any suitable chemical vapor deposition technique known in the art. Aluminum nitride has a coefficient of thermal expansion of 5.6 ppm/°C and a use temperature of 1375°C. Further, it may be removed using KOH, NaOH or 2H₂O*2HNO₃*1H₂SO₄.

The barrier coating layer 16 is formed from alumina and may have a thickness in the range of from 15 to 25 microns. The barrier coating layer 16 may be deposited using any suitable chemical vapor deposition technique known in the art. A barrier coating layer formed from alumina has a coefficient of thermal expansion of 8.5 ppm/°C and a use temperature of about 1800°C. Further, it may be removed using KOH or NaOH.

Having an intermediate layer of intermediate thermal expansion and a functionally graded material allows for a much larger temperature range for which the coating will be stable. The alumina barrier coating grown from the vapor phase has some inherent residual porosity from the competitive growth phase. This often leads to oxidation and degradation of the substrate. The aluminum nitride layer forms a stable oxide that matches the barrier oxide exactly and prevents any further oxidation.

Aluminum nitride has the advantage of having a very high thermal conductivity, making the coating process more efficient. The material is also known to have some resistance to attack by molten alloys providing extra protection for a short period of time should the alumina barrier coating fail during casting.

The aluminum nitride bond coat of the present invention increases adherence and lowers thermal mismatch stress. Still further, it provides critical benefits to the refractory metal core coating such as oxidation resistance. The multi-layer coating of the present invention allows for the control of residual thermal stress and dissolution resistance in the molten alloy. The bond coat of the present invention has the following properties: (1) oxidation barrier; (2) stable oxide former; (3) resistance to molten alloy; (4) intermediate coefficient of thermal expansion between substrate and barrier coating; and (5) leachable with a method for core removal.

## Claims

1. An article which comprises a refractory metal core (12) and a layer (14) of aluminum nitride deposited onto a surface of the refractory metal core (12); **characterised in that** said refractory metal core (12) is formed from a metal selected from the group consisting of molybdenum and molybdenum alloys and **in that** it further comprises an alumina barrier coating material layer (16) deposited onto said aluminum nitride layer (14).

2. The article according to claim 1, wherein said refractory metal core (12) is formed from rolled molybdenum foil.

3. The article according to claim 1 or 2 wherein said aluminum nitride layer (14) has a thickness of less than 50 microns.

4. The article according to claim 3, wherein said thickness is in the range of from 3.0 to 5.0 microns.

5. The article according to any preceding claim, wherein said alumina layer (16) has a thickness in the range of from 15 to 25 microns.

6. The article according to any preceding claim, wherein said refractory metal core (12) has a thickness in the range of from 300 to 500 microns.

7. An article as claimed in any preceding claim wherein said article is a refractory metal core system (10) for use in casting a product.

8. A method for forming a refractory metal core system (10) for use in a casting system, said method comprising the steps of providing a refractory metal core (12) and depositing a layer (14) of aluminum nitride onto a surface of the refractory metal core (12); **characterised in that**:
the refractory metal core providing step comprises providing a substrate (12) formed from a metal selected from the group of molybdenum and molybdenum alloys; and by:
depositing a barrier coating layer of alumina over said aluminum nitride.

9. The method according to claim 8, wherein the refractory metal core providing step comprises providing a rolled foil formed from molybdenum.

10. The method according to claim 8 or 9, wherein the aluminum nitride depositing step comprises depositing a layer (14) of said aluminum nitride having a thickness less than 50 microns.

11. The method according to claim 10, wherein the aluminum nitride depositing step comprises depositing a layer (14) of said aluminum nitride having a thickness in the range of 3.0 to 5.0 microns.

12. The method according to any of claims 8 to 11, wherein said alumina layer depositing step comprises depositing an alumina layer (16) having a thickness in the range of from 15 to 25 microns.

## Patentansprüche

1. Gegenstand, der einen Kern (12) aus schwerschmelzendem Metall und eine Schicht (14) aus Aluminiumnitrid, die auf einer Oberfläche des Kerns (12) aus schwerschmelzendem Metall abgeschieden ist, aufweist; **dadurch gekennzeichnet, dass** der Kern (12) aus schwerschmelzendem Metall aus einem Metall hergestellt ist, das ausgewählt ist aus der Gruppe, die aus Molybdän und Molybdänlegierungen besteht, und dadurch, dass er außerdem eine Schicht (16) aus Aluminiumoxid-Barrierebeschichtungsmaterial aufweist, die auf der Aluminiumnitrid-Schicht (14) abgeschieden ist.

2. Gegenstand nach Anspruch 1, wobei der Kern (12) aus schwerschmelzendem Metall aus gewalzter Molybdänfolie hergestellt ist.

3. Gegenstand nach Anspruch 1 oder 2, wobei die Aluminiumnitrid-Schicht (14) eine Dicke von weniger als 50 Mikrometern hat.

4. Gegenstand nach Anspruch 3, wobei die Dicke in dem Bereich von 3,0 bis 5.0 Mikrometern ist.

5. Gegenstand nach einem vorangehenden Anspruch, wobei die Aluminiumoxid-Schicht (16) eine Dicke in dem Bereich von 15 bis 25 Mikrometern hat.

6. Gegenstand nach einem vorangehenden Anspruch, wobei der Kern (12) aus schwerschmelzendem Metall eine Dicke in dem Bereich von 300 bis 500 Mikrometern hat.

7. Gegenstand wie in einem vorangehenden Anspruch beansprucht, wobei der Gegenstand ein System (10) mit einem Kern aus schwerschmelzendem Metall zur Verwendung beim Gießen eines Produkts ist.

8. Verfahren zur Herstellung eines Systems (10) mit einem Kern aus schwerschmelzendem Metall zur Verwendung in einem Gusssystem, wobei das Verfahren die Schritte des Bereitstellens eines Kerns (12) aus schwerschmelzendem Metall und des Abscheidens einer Schicht (14) aus Aluminiumnitrid auf einer Oberfläche des Kerns (12) aus schwerschmelzendem Metall aufweist; **dadurch gekennzeichnet, dass**:
der Schritt des Bereitstellens des Kerns aus schwerschmelzendem Metall ein Bereitstellen eines Substrats (12), das aus einem Metall hergestellt wird, das ausgewählt wird aus der Gruppe von Molybdän und Molybdänlegierungen, aufweist: und durch:
Abscheiden einer Barrierebeschichtungs-Schicht aus Aluminiumoxid über dem Aluminiumnitrid.

9. Verfahren nach Anspruch 8, bei dem der Schritt des Bereitstellens des Kerns aus schwerschmelzendem Metall ein Bereitstellen einer gewalzten Folie, die aus Molybdän hergestellt ist, aufweist.

10. Verfahren nach Anspruch 8 oder 9, bei dem der Schritt des Abscheidens von Aluminiumnitrid ein Abscheiden einer Schicht (14) aus dem Aluminiumnitrid mit einer Dicke von weniger als 50 Mikrometern aufweist.

11. Verfahren nach Anspruch 10, bei dem der Schritt des Abscheidens des Aluminiumnitrids ein Abscheiden einer Schicht (14) aus dem Aluminiumnitrid mit einer Dicke in dem Bereich von 3.0 bis 5,0 Mikrometern aufweist.

12. Verfahren nach einem der Ansprüche 8 bis 11, bei dem der Schritt des Abscheidens der Aluminiumoxid-Schicht ein Abscheiden einer Aluminiumoxid-Schicht (16) mit einer Dicke in dem Bereich von 15 bis 25 Mikrometern aufweist.

## Revendications

1. Article comprenant un substrat en métal réfractaire (12) et une couche (14) de nitrure d'aluminium déposée sur une surface du substrat en métal réfractaire (12), **caractérisé en ce que** ledit substrat en métal réfractaire (12) est formé d'un métal sélectionné dans le groupe constitué du molybdène et d'alliages de molybdène et **en ce qu'**il comprend en outre une couche de matériau de revêtement barrière constituée d'alumine (16) déposée sur ladite couche de nitrure d'aluminium (14).

2. Article selon la revendication 1, dans lequel ledit substrat en métal réfractaire (12) est formé d'une feuille de molybdène laminé.

3. Article selon la revendication 1 ou 2, dans lequel ladite couche de nitrure d'aluminium (14) a une épaisseur inférieure à 50 microns.

4. Article selon la revendication 3, dans lequel ladite épaisseur est de 3,0 microns à 5,0 microns.

5. Article selon l'une quelconque des revendications précédentes, dans lequel ladite couche d'alumine (16) a une épaisseur de 15 microns à 25 microns.

6. Article selon l'une quelconque des revendications précédentes, dans lequel ledit substrat en métal réfractaire (12) a une épaisseur de 300 microns à 500 microns.

7. Article selon l'une quelconque des revendications précédentes, ledit article étant un système de substrat en métal réfractaire (10) destiné à une utilisation dans la coulée d'un produit.

8. Procédé de fabrication d'un système de substrat en métal réfractaire (10) destiné à une utilisation dans un système de coulée, ledit procédé consistant à fournir un substrat en métal réfractaire (12) et à déposer une couche (14) de nitrure d'aluminium sur une surface du substrat en métal réfractaire (12), **caractérisé en ce que** :
l'étape de fourniture du substrat en métal réfractaire consiste à fournir un substrat (12) formé d'un métal sélectionné dans le groupe constitué du molybdène et d'alliages de molybdène ; et par :
le dépôt d'une couche de revêtement barrière constituée d'alumine sur ledit nitrure d'aluminium.

9. Procédé selon la revendication 8, dans lequel l'étape de fourniture du substrat en métal réfractaire consiste à fournir une feuille laminée formée de molybdène.

10. Procédé selon la revendication 8 ou 9, dans lequel l'étape de dépôt du nitrure d'aluminium consiste à déposer une couche (14) dudit nitrure d'aluminium ayant une épaisseur inférieure à 50 microns.

11. Procédé selon la revendication 10, dans lequel l'étape de dépôt du nitrure d'aluminium consiste à déposer une couche (14) dudit nitrure d'aluminium ayant une épaisseur de 3,0 microns à 5,0 microns.

12. Procédé selon l'une quelconque des revendications 8 à 11, dans lequel l'étape de dépôt de ladite couche d'alumine consiste à déposer une couche d'alumine (16) ayant une épaisseur de 15 microns à 25 microns.
